# EUROPEAN PATENT APPLICATION

(11) **EP 1 035 580 A2**
(43) Date of publication of application: **13.09.2000**
(21) Application number: 00301805.8
(22) Date of filing: 06.03.2000
(51) Int. Cl.: H01L 23/498, H01L 21/58, H01L 23/31

(54) **Method and structure for integrated circuit package**

(30) Priority: 05.03.1999 US 123116 P; 24.03.1999 US 126234 P
(71) Applicant: Altera Corporation, San Jose, California 95134 (US)
(72) Inventor: Anderson, Sidney Larry, Fremont, CA 94539 (US); Long, Jon, Livermore, CA 94550 (US); Fritz, Donald S., San Jose, CA 95136 (US)
(74) Representative: O'Connell, David Christopher

(57) **Abstract**

An integrated circuit package is constructed to potential reduce stress and damage to an integrated circuit die. A rigid transition medium (220) is attached using adhesive layers (215, 42) and interfaces between a tape carrier (260) and the integrated circuit die (210). The integrated circuit package prevents damage such as die cracks and also enhances the service life of the packaged integrated circuit part.

## Description

The application claims priority to U.S. Provisional Application 60/123,116, filed March 5, 1999, and U.S. Provisional Application Number 60/126,234, filed March 24, 1999, and is related to U.S. Nonprovisional Application No / filed (Attorney Docket Number 015114-052410US), which are incorporated by reference.

### BACKGROUND OF THE INVENTION

The present invention relates to the field of integrated circuit technology, and more specifically to techniques of packaging integrated circuits.

Integrated circuits (ICs) or "chips" are becoming denser and are providing higher performance and functionality per unit area. Many ICs have hundreds of pads that will interface with the printed circuit board (PCB). The packaging for the IC connects the pads of the chip to the pins, leads, or other electrical contacts of the package.

It is important that the IC package is relatively low in cost. Previous generations of IC packages were ceramic or included materials or used techniques that increased the cost of the packaging. It is also important that the IC packaging sufficiently protect the chip and provide the necessary number of electrical connections (e.g., leads), and provide this function using as small a package size as possible. A package with a smaller footprint takes up less PCB space and more ICs can be mounted on a single PCB.

Another important consideration in IC packaging is reliability. One concern is that when an IC package is soldered to the PCB, the IC package should be reliably electrically connected to the PCB, or else over time open circuit or no connection failures will result. Because temperature cycling occurs when the IC heats up during operation and cools off during non-operation, the solder ball connections between the IC and the PCB may be subjected to shear and stress forces due to the package expansion and contraction. The solder balls may work harden and then fracture. Cracks in the solder balls will cause open circuits, which inevitably leads to system failure. Consequently, it is quite important to design the IC package so that the temperature cycling does not cause premature solder joint and system failure.

Therefore, as can be appreciated, methods and devices are needed to provide IC packaging with a lower cost, smaller package size, and better reliability. Specifically, there is a need to design integrated circuit packages which enhance solder ball reliability and longevity while maintain the small size of the package and large amount of contacts between the die and the PCB.

### SUMMARY OF THE INVENTION

The present invention provides a stress relief buffer zone between the die and the solder ball array which absorbs the mechanical and thermal stress from temperature cycling. A transition medium relieves the stress above and below the die and acs as the stress buffer zone. The transition medium also moves the die towards the center of the packaging and allows the molding compound and transition medium to expand and contract while keeping the die relatively motionless. By moving the die towards the middle of the packaging, the transition medium reduces the warpage and curling of the package. The reduction of the warpage and curling increases the life of the solder ball joint, and accordingly increases the life of the electronic device. The transition medium is typically composed of a stress absorbent material, and has a CTE similar to the mold compound, the PCB, or both.

In a first aspect, the present invention provides an integrated circuit package comprising a silicon die having a first thickness and a metallized polymer layer having a first and second side. A transition medium is disposed between the silicon die and the first side of the metallized polymer layer. The transition medium has a second thickness which is greater than the first thickness of the silicon die.

In another aspect, the present invention provides an integrated circuit package comprising a metallized polymer layer defining a first thickness. A transition medium is coupled to the metallized polymer layer. A die is coupled to the transition medium. A mold cap encapsulates the transition medium and the die. The mold cap defines a second thickness, such that the first thickness of the metallized polymer layer and the second thickness of the mold cap define a package thickness. The die is disposed near the middle of the package thickness.

In yet another aspect, the present invention provides an integrated circuit comprising a first adhesive layer with a coefficient of thermal expansion disposed on a tape carrier. A transition medium having a first and second surface is mounted on the first adhesive layer such that the first surface of the transition medium engages the first adhesive layer. A second adhesive layer is disposed on the second surface of the transition medium and a die is disposed on the second adhesive layer. A mold cap encapsulates the first adhesive layer, the transition medium, the second adhesive layer, and the die. The mold cap and tape carrier define a package thickness. The coefficient of thermal expansion of the transition medium and the mold cap have approximately the same coefficient of thermal expansion so as to reduce the thermal stress on the die during thermal cycling.

In a further aspect the present invention provides a method of packaging an integrated circuit. The method comprises providing a silicon die adhered to a rigid transition medium. A layer of adhesive is applied to a tape carrier. The die and transition medium are mounted to the adhesive on the tape carrier. The die and transition medium is then encapsulated.

In yet another aspect, the present invention provides a method of forming an integrated circuit package. The method comprises providing a metallized polymer layer. A rigid transition medium layer is attached to the metallized polymer layer through a first adhesive layer. An integrated circuit is coupled to the rigid transition medium using a second adhesive layer.

In yet another aspect, the present invention provides a method of fabricating an integrated circuit. The method comprises providing a semiconductor wafer. The semiconductor wafer is attached to a transition medium using a first adhesive. A die is cut from the semiconductor wafer, wherein the die is attached to a corresponding area of the transition medium. The die and transition medium are mounted to a tape carrier.

In yet another aspect, the present invention provides a method of forming an integrated circuit package comprising providing a tape carrier and a silicon die. The thermal mismatch stress between the die and the integrated circuit package is reduced by disposing a rigid transition medium between the tape carrier and the silicon die.

Other objects, features, and advantages of the present invention will become apparent upon consideration of the following detailed description and the accompanying drawings, in which like reference designations represent like features throughout the figures.

### BRIEF DESCRIPTION OF THE DRAWINGS

Figure 1 is a cross-sectional view of an integrated circuit package;
Figure 2 is an exploded view taken from Figure 1;
Figure 3 is a cross sectional view of a BGA package with a die near the bottom of the packaging;
Figure 4 illustrates the warpage and curling of the BGA package due to the temperature differentials of the package components;
Figure 5 is a cross-sectional view of an integrated circuit package according to one embodiment of the present invention;
Figure 6 is an exploded view taken from Figure 5;
Figure 7 is a cross sectional view of a integrated circuit package having a die near the center of the package;
Figure 8 is a top-view of a chip package according to the embodiment shown in Figure 5;
Figures 9A to 9F illustrate a method of the present invention;
Figures 10A to 10E illustrate another method of the present invention;
Figures 11A to 11F illustrate yet another method of the present invention; and
Figures 12A to 12C illustrates another method of the present invention.

### DETAILED DESCRIPTION

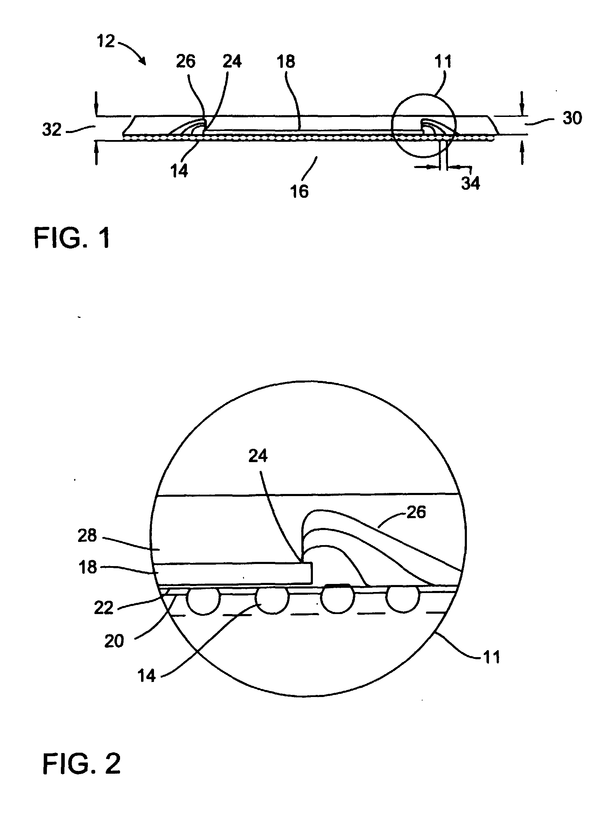

Figure 1 shows a cross-sectional view of an integrated circuit (IC) package 12. The package is a ball grid array (BGA) package. The pins or leads for the package are solder balls 14 arranged in a grid or array pattern on the underside of the package. The package is typically surface mounted on a PC board 16 using solder balls 14. BGA packages can accommodate higher numbers of I/O pins because a greater numbers of solder ball leads 14 can be placed in a grid array pattern underneath the package. For example, some BGA packages have 672 or more solder ball leads 14, while PLCC packages are often limited to 304 leads.

It is understood that although the present invention will be described in relation to the BGA package types, the present invention is applicable to package types other than the BGA type. The present invention is applicable to any package which has electrical leads which are subject to stress. In fact, as the semiconductor continues to advance, there will undoubtedly be new package types that do not yet exist or have not yet become standardized. The principles of the present invention will also be applicable to the new package types as well.

Many types of integrated circuits are being designed to have greater numbers of I/O pins. Microprocessors, ASICs, PLDs, and FPGAs generally can have high I/O pin counts. For example, the Altera Fine Line BGA package has 672 pins. Some examples of products using BGA packages include Altera's 10K family of Fine Line™ and SameFrame™ products. The terms "solder ball," "lead," and "pin" are used interchangeably throughout the specification and are used to signify electrical contact points between the IC package and a substrate such as a printed circuit board (PCB).

BGA packages will have a better lead density (pins per square inch) and support a greater number of input/output (I/O) pins than other PLCC, QFP, and PGA packages of the same size. The areas of the BGA package typically has an area of 11 square millimeters, 17 square millimeters, 23 square millimeters, 27 square millimeters, 35 square millimeters, 45 square millimeters, or larger package sizes. Naturally, it will be appreciated that the package size will vary depending on the function of the chip and the electronic device. It is expected that the solder ball count of the BGA packages will increase since the trend is to produce even more highly integrated circuitry. This is especially true for ICs such as microprocessors, ASICs, and CPLDs. Such large numbers of solder balls will provide electrical connections between a PCB and an ever increasing number of I/O pins. BGA packages can have 100, 256, 484, 672, 2000, or more solder balls.

Figure 1 illustrates a BGA package 12 comprising a silicon die 18 mounted to a metallized polymer tape 20 through a die attach 22. Metallized polymer tape 20 comprises traces that route each pad 24 of die 18 to appropriate solder ball landing areas. Metal wires 26 electrically connect die 18 to solder balls 14 through the etched circuit leads to electrically connect the chip to the PC board. Die 18 and metal wires 26 are encased or encapsulated using mold cap 28, to protect the semiconductor die and package components from various stresses such as temperature stress and mechanical stress. A thickness 30 of package 12 is approximately 0.060 inches. A thickness 32 of package 12, including solder balls 14, is approximately 0.073 inches. A width 34 of a solder ball 14 is approximately 0.019 inches. Naturally, the package dimensions can vary depending on the size of the silicon die 18, the number of I/O pins, the number and size of the solder balls 14, and similar factors.

Figure 2 shows an exploded view of section 11 of Figure 1. Silicon die 18 contains electronic circuitry. Some examples of IC chips include microprocessors, programmable logic, ASICs, DSPs, and broadband ICs. Die 18 can be made of materials other than silicon such as gallium arsenide, or the like. Input/output bonding wires 26 are electronically coupled to pads 24 of die 18 at appropriate locations on tape carrier 20. Bonding wires 26 can be composed of conducting materials, such as aluminum, gold, copper, silver, or the like. Die 18 is attached to tape carrier 20 using an adhesive or die attach 22. Die attach 22 can be one of many materials that can sufficiently bond die 18 to tape carrier 20. For example, die attach materials can include latex cements; thermosetting adhesives such as epoxies, cyanoacrylates, acrylics, and polyesters; thermoplastic adhesives such as polyesters, polyvinal acetals, acrylics, and polyamides; cellulose acetates; elastomer adhesives such as urethanes, silicones, neoprecores, and natural rubbers; and alloy adhesives such as epoxy-nylons, epoxy polysulfides, and vinyl phnolics.

The BGA package employs a tape package construction that provides greater flexibility for routing die-to-package terminations. In a BGA package, the bonding wires electrically couple the pads of the die to pads or traces on the tape carrier. This tape carrier has traces (like a PC board) that routes each pad of the die to appropriate solder ball landing area. Therefore, by changing the traces of the tape carrier, the routability to solder ball connections underneath the die can be flexibly changed. This reduces the package size compared to PLCC and other package types. Current tape package technology typically supports twenty five micron traces within a twenty five micron space. The tape technology is about twice as effective as the closest competitive technology. The tape carrier is typically made on a continuous flexible printed circuit material with conducting traces, such as a polyimide film tape. These traces can be made of a conducting material such as copper, metallized polymer layers, or the like.

Table 1 lists typical dimensions of various package components.

**TABLE 1**

| **Package Component** | **Typical Dimensions** |
|---|---|
| Mold cap | 0.7 to 1.5 square millimeters |
| Bonding wires | 0.8 to 1.3 (doped gold wire) |
| Silicon die | 6 to 10 mils |
| Adhesive | 2 to 4 mils |
| Solder balls | 18 to 25 mils |
| Tape carrier | 2 to 3 mils (w/ 1 mil metallization) |

Despite the success of tape package construction, there are potential problems. One concern is the reliability of the solder ball joints between the BGA package and the PCB. Because a system is turned on and off, there is expansion and contraction of the BGA package and the PCB due to the temperature cycling. In particular, solder balls 14 experience shear stress due to the mismatched coefficients of thermal expansion (CTE) among the various components of the device. Such a problem arises, for example, when the CTE of the silicon die is sufficiently mismatched with the CTE of the PCB onto which the components are mounted. Such differences can be large. For example, the typical CTE of a die can be as low as 2.6 x 10⁻⁶/°C and that of a PCB can be as high as 17 x 10⁻⁶/°C.

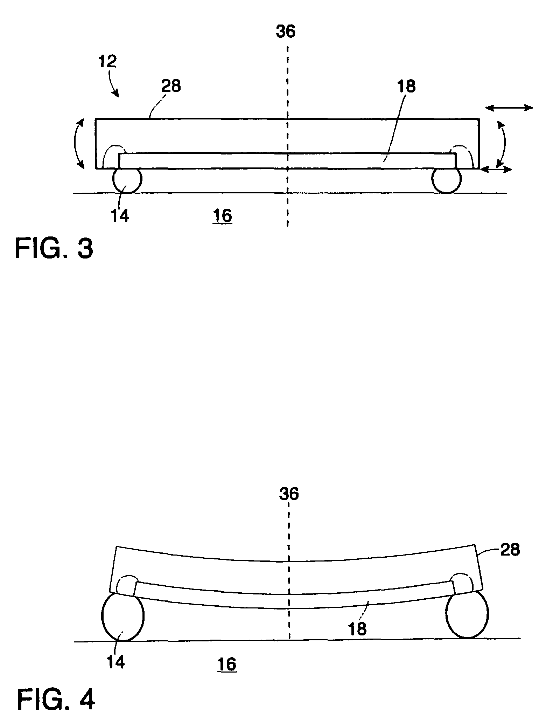

A problem stemming from the mismatched CTEs is IC package warpage or curling. Specifically, the IC package expands and shrinks more than the die. Figures 3 and 4 illustrate an integrated circuit package 12 coupled to PCB 16 with solder balls 14. Because of the symmetry of the packaging, expansion and shrinkage proceeds outward from the stationary central point 36 of the package. As shown in Figure 3 die 18 typically sits near the bottom of packaging 12. Because the CTE of the die is smaller than the CTE of plastic encapsulant 28, the bottom of the package does not expand and contract as much as the top of the package. As shown in Figure 4, this tends to pull the lower edges of the package upward and tends to curl package 12. This subjects the outermost solder balls to large shear and bending forces. Thus, the solder balls that typically fail first are those that are positioned furthest away from the center of the IC package. The open connection from the cracked solder ball inevitably leads to a system failure.

Table 2 lists typical CTEs for various package components.

**TABLE 2**

| **Package Component** | **Typical CTEs (1 x 10**^{**-6**}**/°C)** |
|---|---|
| Moldcap | 7 to 15 |
| Silicon die | 2.6 to 6 |
| Adhesive | 58 |
| Package substrate | 12 to 17 |
| Solder balls | 24 |
| Tape carrier | 12 |
| PCB | 17 |

Larger packages tend to experience more failures than smaller packages because the larger packages experience more expansion than smaller packages. Consequently, the larger die sizes have a significant effect on solder ball joint reliability. For example, for die sizes less than 3 square millimeters, the number of failure-free cycles can be as high as 5000 cycles. The number of failure-free cycles, however, drop below 2000 cycles for die sizes greater than 5 square millimeters and down to 1000 cycles for die sizes greater than 10 square millimeters.

One technique to improve solder ball reliability is using bigger and taller solder balls. Bigger solder ball increase the area of contact between the solder ball and the PCB and increase the life of the solder ball joint. One problem with bigger solder balls is the limited space on the die packages. Bigger solder balls take up more space, and decrease the potential number of electrical contacts between the die and PCB.

Taller solder balls increase the distance between the solder ball and the PCB, and allow more swing between the top and bottom of the solder ball. This can lower the contention at the solder ball joints. One problem with taller solder balls, however, is they raise the overall height of the die package which is contrary to the goal of minimizing package sizes.

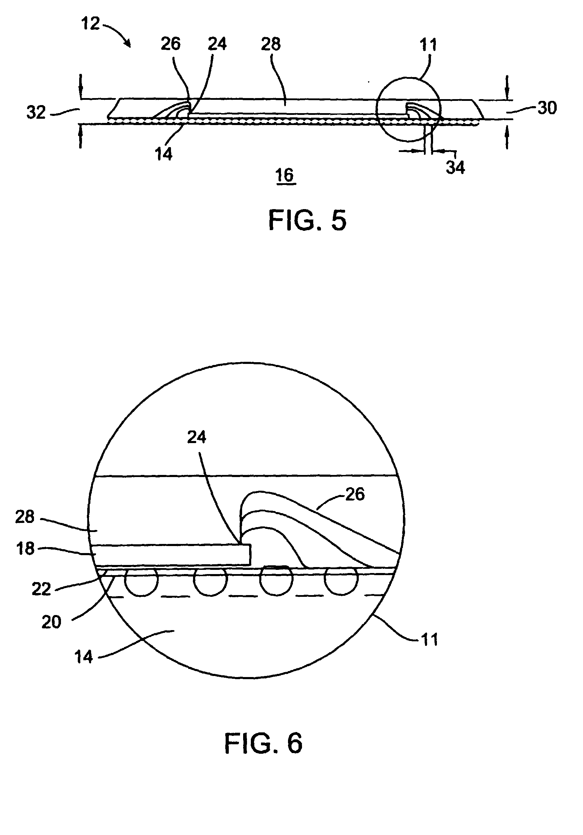

Figure 5 shows a cross-sectional view of an embodiment of the integrated circuit package 200 of the present invention. Similar to Figures 1 and 2, a thickness 30 of package 12, including tape carrier 20 and plastic encapsulant 28, is typically about 0.060 inches. A thickness 32 of package 12 with solder balls 14 is typically about 0.073 inches. A width 34 of a solder ball is typically about 0.0 19 inches. Naturally, the dimensions of the components of the package will change depending on factors such as the size of the die, the number of I/O pins, the number and size of the solder balls, and the like.

As shown most clearly in Figure 6, the integrated circuit package has a transition medium 42 between tape carrier 20 and the silicon die 18. A first adhesive 38 adheres transition medium 42 to tape carrier 20, and a second adhesive 40 adheres die 18 to transition medium 42. The active region of die 18 faces away from tape carrier 20. Bonding wires 26 couple pads or other features 24 of silicon die 18 to appropriate locations on the tape carrier. Naturally, it will be appreciated that the transition medium 42 can be coupled to silicon die 18 and tape carrier 20 using other conventional methods, such as transfer or injection molding.

The IC package in Figures 5 and 6 provides improved reliability with respect to mismatched CTE stress and die positioning. Transition medium 42 acts as a buffer and absorbs much of the stress at a solder ball joint 44 between package 12 and PCB 16. Transition medium 42 material should be rigid enough to support the die. The transition medium may include materials such as mold compound 28, BT resin, FR-4 resin, FR-5 resin, polymers, elastomer, adhesives, and the like. While it is possible to use nonpolymers such as a metal or silicon, it has been found that the other materials provide better stress absorption than the metals and silicon. All of these materials, however, are desirable because they have a CTE which is similar to the PCB, mold compound materials, or both. Transition medium 42 typically has a CTE between approximately 7 x 10⁻⁶/°C and 17 x 10⁻⁶/°C, and preferably between 7 x 10⁻⁶/°C and 12 x 10⁻⁶/°C. Such a CTE provides a similar CTE to the surrounding PCB and mold compound and provides a more uniform contraction and expansion of the die packaging 12.

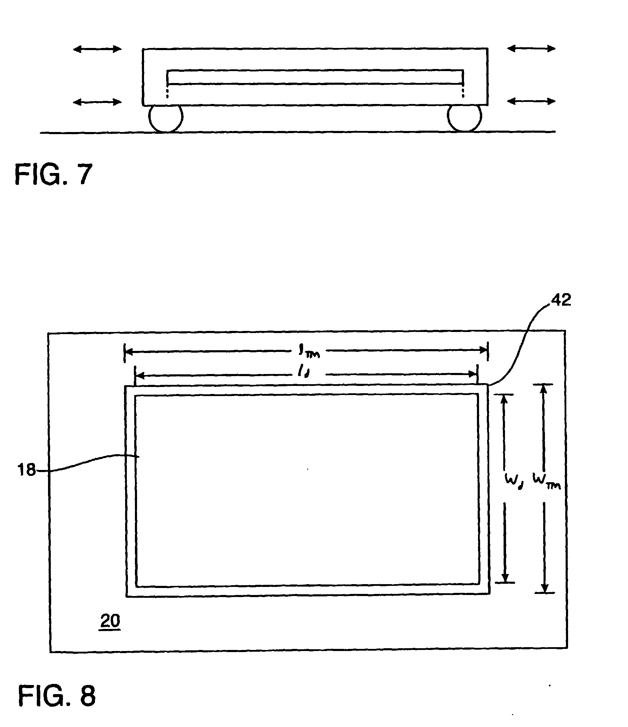

Transition medium 42 positions the die closer to the middle of package thickness 30. Having the die 18 near the middle of the package thickness 30 reduces the problem of package warpage and curling. The top and the bottom of the package can contract more equally and the forces on the die can be reduced. As shown in Figure 7, when mold compound 28 and transition medium 42 expand and contract, because the die is near the center, the die's movement will be minimized. Moreover, positioning the die 18 closer to the middle moves the die farther from the solder ball array and reduces the stress on the die 18. Accordingly, die 18 can be made thinner without jeopardizing its integrity. The die thickness can be reduced from 18 mils down to 1 mil or less by plasma etching, mechanical grinding, lapping, or the like. In a specific embodiment, the die is reduced to a thickness of 6 mils by plasma etching. Although other techniques are available, plasma etching is used because thickness down to about 2 mils may be obtained. Thus, in many embodiments dies 18 is thinner than transition medium 42. Because the die is thinner, there is less die material and the thermal mismatch stress should be reduced.

Figure 8 shows a top view according to the embodiment shown in Figure 7. Specifically, Figure 8 illustrates the die 18, transition medium 42, and tape carrier 20. In the illustrated embodiment, the transition medium 42 length lₜₘ and width wₜₘ are at least as long and wide as the die 18 length l_{d} and width w_{d}. In other embodiments, the transition medium 42 can have a smaller or larger area than the die. The die and transition medium can be any number of shapes, including but not limited to circular, rectangular, square, or the like. While solder balls 14 can be positioned anywhere on the packages, in this embodiment, solder balls 14 are disposed underneath both the tape carrier 20 and die 18.

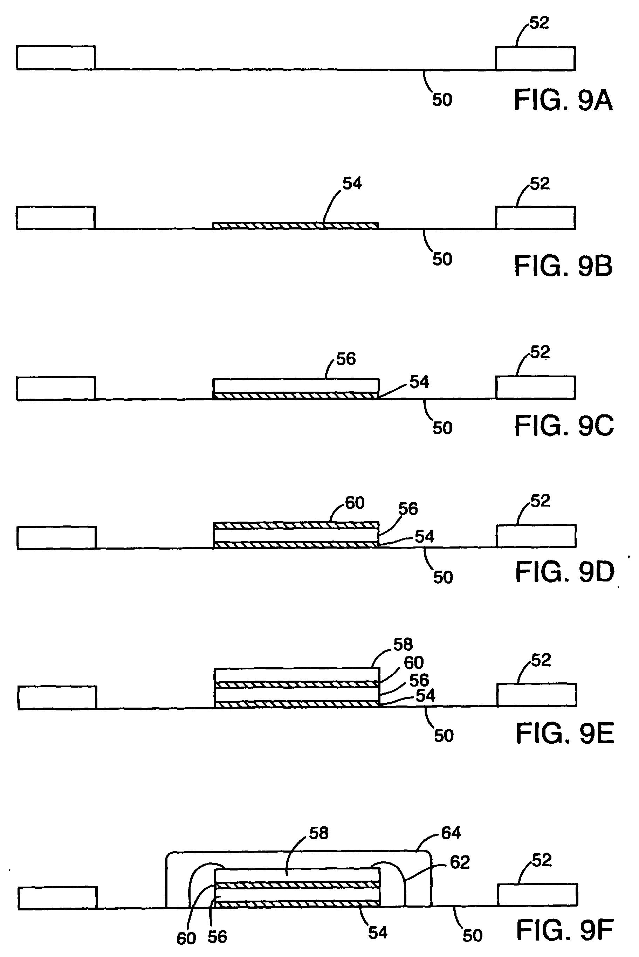

An integrated circuit package of the present invention may be formed in a number of ways and for use in a number of different applications. One method for producing the present invention is illustrated in Figures 9A to 9F. As shown in Figure 9A, a conventional tape carrier 50 having a patterned conductive layer and a dielectric layer having vias is typically mounted beneath a copper support frame 52 prior to processing. Any conventional two layer or three layer polyimide tape carrier can be used. A first layer of adhesive 54 can be applied to polyimide tape carrier 50 (Figure 9B). Any standard technique of applying the adhesive can be used. For example, a standard heat press technique, b stage (application and partial cure), or the like can be used. Before being attached to tape carrier 50, transition medium 56 can be precut to a size at least as large as the die that will be used. Transition medium 42 length lₜₘ and width wₜₘ should be at least as long and wide as die 58 length l_{d} and width w_{d}. (See Figure 8). As shown in Figure 9C, transition medium 56 is then mounted onto the first layer of adhesive 54. A second layer of adhesive 60 is applied to the top surface of the transition medium 56 (Figure 9D). A die 58 is typically thinned by back lapping, polishing methods, plasma etching, or the like, prior to mounting on the second adhesive layer (Figure 9E). Bonding wires 62 can be attached to pads or other features of the die 58 to electrically connect the die to appropriate locations on tape carrier 50. Die 18 can then be encased or encapsulated using mold cap 64. (Figure 9F).

Solder balls or other conductive balls can thereafter be positioned to electrically connect the tape carrier electrical traces to the printed circuit board using any conventional method suitable for forming a secure electrical connection between the solder balls and the pads (not shown). For example, the solder balls may be added through solid or liquid deposition followed by infrared, convection, vapor phase, soldering, or the like.

The combination of the adhesive layers 54, 60, transition medium 56, and die 58, typically have a thickness between approximately 14 mils and 20 mils, and preferably approximately 18 mils. Naturally, the relative thicknesses can vary depending on materials, overall thickness of the package, and the type of device. In an exemplary embodiment, adhesive layers 54, 60 have a thickness of 2 mils, transition medium 56 has a thickness of approximately 10 mils and die has a thickness of approximately 6 mils. Typically, there is no bonding wire between the transition material and the die. The transition material need not be grounded for this invention to work well. Although the illustrated embodiments employ a single transition medium, it will be understood that more than one transition medium may be employed. For example multiple layers of materials having different CTEs or multiple layers of the material having the same CTE maybe by disposed between the die and the solder balls. Moreover, transition medium 56 may have gaps which allow the mold encapsulant to intervene in an area directly between die 58 and tape carrier 50.

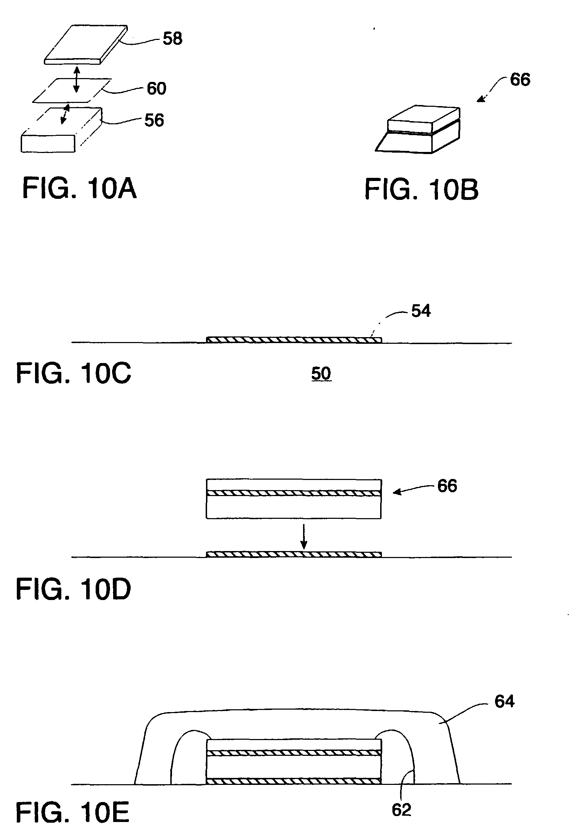

Figures 10A to 10E illustrate an alternative method of producing the present invention. In particular, die 58 and transition medium 56 are adhered together prior to mounting on the tape carrier 50. As shown in Figures 10A and 10B, transition medium 56 is attached to die 58 with an adhesive layer 60 to form sandwich 66. A second adhesive layer 54 can be applied to a surface of tape 54 at the desired position. (Figure 10C). The sandwich 66 can then be attached to the second adhesive layer 54 (Figure 10D). Bonding wires 62 can be attached to the pads or other features of the die 58 to electrically connect die 58 to the tape carrier 50. Die 58 can then be encased or encapsulated using a mold cap 64. (Figure 10E).

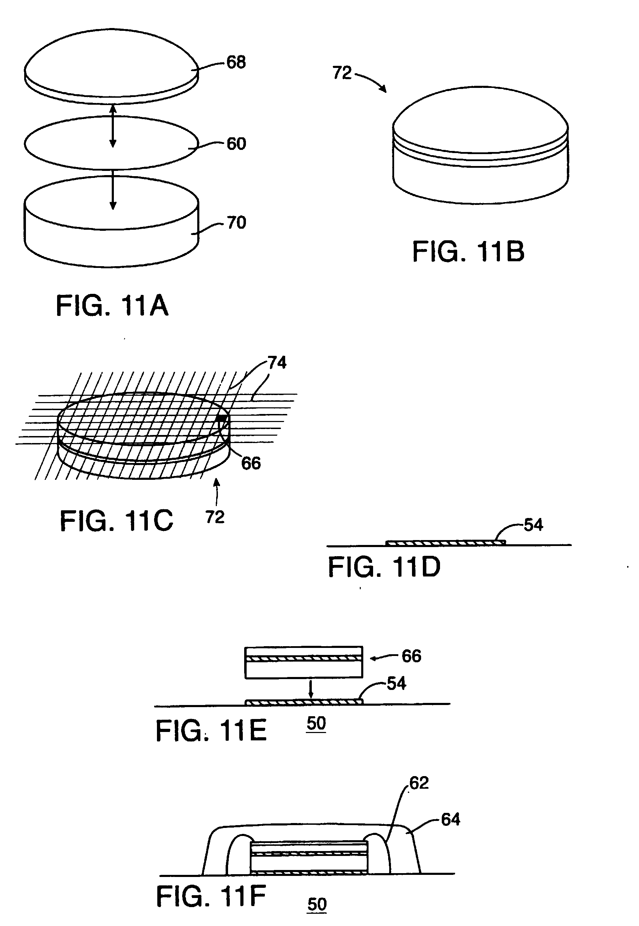

Figures 11A to 11F illustrate another method of producing the present invention. Instead of placing the die directly onto the adhesive layer, semiconductor wafers are adhered to a transition medium and ten processed to produce sandwiches 66. This process provides more accurate alignment between die 58 and transition medium 56 when mounted on tape carder 50. In comparison, the techniques of Figures 9A to 9F require more careful alignment of the structures. The transition material needs to be aligned and placed in the package and the die needs to be aligned and placed on the transition medium. The techniques of Figure 11A to 11F does not require as many or as precise alignment steps. In fact the assembly of the die and transition material combination can be performed in the same way or is done with a single die. As shown in Figures 11A and 11B, semiconductor wafer 68 is adhered to a transition medium 70 with an adhesive layer 60 to form combination 72. Wafer 68 can be any size or shape, but is typically a circular wafer having a diameter between approximately 6 inches and 12 inches. Wafer 68 typically has a thickness between approximately 18 mils and 30 mils, but can be thinned with plasma etching or lapping to provide any desired thickness. In one embodiment, transition medium 56 length L_{TM} and width W_{TM} are at least as long and wide as the semiconductor wafer 68 length L_{D} and width W_{D}. In other embodiments, transition medium 70 can be larger or smaller than wafer 68. After wafer-transition medium combination 72 has been set, it is cut into pieces, as shown by lines 74 of Figure 11B to form the sandwiches 66. The exact size and shape of each sandwich 66 will depend on the desired application. The cutting can be done by any conventional means such as mechanical sawing, laser sawing, punching (shearing), or the like. A second layer of adhesive 54 is placed on the tape carrier 50 (Figure 11C). As illustrated in Figures 11D and 11E, the sandwich 66 is then placed on the adhesive layer 54. Bonding wires 62 can be attached to pads or other features of die 58 to electrically connect the die to appropriate locations on tape carrier 50. Die 58 can then be encased or encapsulated using mold cap 64 (Figure 11F).

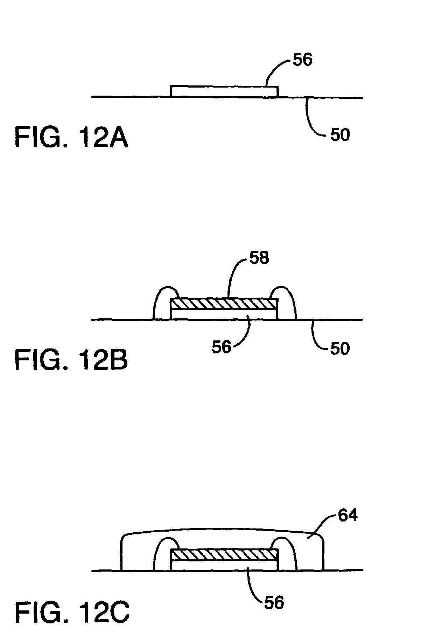

In yet another method shown in Figures 12A to 12C, a pre-molded pedestal 56 can be integrally formed on the substrate 50. The die 58 can be positioned directly on the pedestal 56 with or without an adhesive. Thereafter, the mold encapsulate 64 can be placed over the pedestal 56 and the die 58 to seal the integrated circuit. In most embodiments the pre-molded pedestal is comprised of the same material as the mold encapsulate, however, in other embodiments, the pre-molded pedestal can be other materials which have similar CTE's as the molding compound.

This description of embodiments of the invention is presented for the purposes of illustration and description. It is not intended to be exhaustive or to limit the invention to the precise form described, and many modifications and variations are possible in light of the teaching above. The embodiments were chosen and described in order to best explain the principles of the invention and its practical applications. This description of embodiments will enable others skilled in the art to best utilize and practice the invention in various embodiments and with various modifications as are suited to the particular use contemplated.

## Claims

1. An integrated circuit package comprising:
a silicon die having a first thickness;
a metallized polymer layer having a first side and a second side; and
a transition medium disposed between the silicon die and the first side of the metallized polymer layer wherein the transition medium has a second thickness, and the first thickness of the silicon die is less than the second thickness.

2. The integrated circuit package of claim 1 wherein the transition medium is nonconductive.

3. The integrated circuit of claim 1 wherein the transition medium has a coefficient of thermal expansion between approximately 7 x 10⁻⁶/°C and 17 x 10⁻⁶/°C

4. The integrated circuit of claim 1 wherein the integrated circuit metallized polymer layer is a tape carrier having a dielectric layer and a conductive layer.

5. An integrated circuit package comprising:
a metallized polymer layer defining a first thickness;
a transition medium coupled to the metallized polymer layer;
a die coupled to the transition medium; and
a mold cap encapsulating the transition medium and the die, the mold cap defining a second thickness, wherein the first thickness and second thickness define a package thickness, wherein the die is disposed near the middle of the package thickness.

6. The integrated circuit of claim 20 wherein the mold cap has a coefficient of thermal expansion similar to a coefficient of thermal expansion of the transition medium.

7. The semiconductor of claim 20 wherein the die is mounted to the transition medium with a layer of adhesive.

8. An integrated circuit comprising:
a tape carrier;
a first adhesive layer disposed on the tape carrier, the first adhesive layer having a coefficient of thermal expansion;
a transition medium having a first surface and a second surface, wherein the first surface of the transition medium engages the first adhesive layer, the transition medium having a coefficient of thermal expansion;
a second adhesive layer disposed on the second surface of the transition medium, the second layer of adhesive having a coefficient of thermal expansion; and
a die disposed on the second adhesive layer; and
a mold cap encapsulating the first adhesive layer, the transition medium, the second adhesive layer and the die, wherein the mold cap and tape carrier define a package thickness, wherein the transition medium and the mold cap have approximately the same coefficient of thermal expansion so as to reduce the thermal stress on the die during thermal cycling.

9. A method of packaging an integrated circuit comprising:
providing a silicon die adhered to a rigid transition medium;
applying a layer of adhesive to a tape carrier;
mounting the die and transition medium to the adhesive on the tape carrier; and
encapsulating the die and transition medium.

10. The method of claim 26 wherein the providing step is carried out by cutting a semiconductor wafer adhered to a transition medium.

11. A method of fabricating an integrated circuit comprising:
providing a semiconductor wafer;
attaching the semiconductor wafer to a transition medium using a first adhesive;
cutting a die from the semiconductor wafer, wherein the die is attached to a corresponding area of the transition medium; and
mounting the die and transition medium to a tape carrier.

12. The method of claim 35 wherein the cutting step is carried out by mechanical sawing, laser sawing, punching, or shearing.

13. An integrated circuit package comprising:
a die having a first thickness;
a metallized polymer layer having a first side and a second side; and
a transition medium disposed between the die and the first side of the metallized polymer layer wherein the transition medium has a second thickness, and the first thickness of the die is less than the second thickness.

14. A method of packaging an integrated circuit comprising:
providing a die adhered to a rigid transition medium;
applying a layer of adhesive to a tape carrier;
mounting the die and transition medium to the adhesive on the tape carrier; and
encapsulating the die and transition medium.
